# EUROPEAN PATENT SPECIFICATION

(11) **EP 3 391 543 B1**
(45) Date of publication and mention of the grant of the patent: **16.06.2021**
(21) Application number: 16805131.6
(22) Date of filing: 02.12.2016
(51) Int. Cl.: H03K 17/10, H03K 17/284, H02M 1/088

(54) **VOLTAGE BALANCING OF VOLTAGE SOURCE CONVERTERS**
SPANNUNGSAUSGLEICH VON SPANNUNGSQUELLENWANDLERN
ÉQUILIBRAGE DE TENSION DE CONVERTISSEURS DE SOURCE DE TENSION

(30) Priority: 16.12.2015 GB 201522170
(43) Date of publication of application: 24.10.2018
(73) Proprietor: General Electric Technology GmbH, 5400 Baden (CH)
(72) Inventor: CHIVITE-ZABALZA, Javier F., Stafford ST17 4LX (GB); TRAINER, Daivd Reginald, Alvaston Derbyshire DE24 0AQ (GB)
(74) Representative: Brevalex
(86) International application number: PCT/EP2016/079538
(87) International publication number: WO 2017/102373

(56) References cited:
- EP-A1- 3 057 212
- WO-A1-2014/023334
- WO-A1-2014/033155
- US-A1- 2002 057 540

## Description

This application relates to a voltage source converter and to methods and apparatus for control of a director switch of a voltage source converter for voltage balancing, and especially to a voltage source converter for use in high voltage power distribution and in particular to a voltage source converter having converter arms with a director switch having multiple switching elements each having an associated clamp capacitor.

HVDC (high-voltage direct current) electrical power transmission uses direct current for the transmission of electrical power. This is an alternative to alternating current electrical power transmission which is more common. There are a number of benefits to using HVDC electrical power transmission.

In order to use HVDC electrical power transmission, it is typically necessary to convert alternating current (AC) to direct current (DC) and back again. To date most HVDC transmission systems have been based on line commutated converters (LCCs), for example such as a six-pulse bridge converter using thyristor valves. LCCs use elements such as thyristors that can be turned on by appropriate trigger signals and remain conducting as long as they are forward biased and current remains flowing. In LCCs the converter relies on the connected AC voltage to provide commutation from one valve to another.

Increasingly however voltage source converters (VSCs) are being proposed for use in HVDC transmission. HVDCs use switching elements such as insulated-gate bipolar transistors (IGBTs) that can be controllably turned on and turned off independently of any connected AC system. VSCs are thus sometimes referred to as self-commutating converters.

VSCs typically comprise multiple converter arms, each of which connects one DC terminal to one AC terminal. For a typical three phase AC input/output there are six converter arms, with the two arms connecting a given AC terminal to the high and low DC terminals respectively forming a phase limb. Each converter arm comprises an apparatus which is commonly termed a valve and which typically comprises a plurality of elements which may be switched in a desired sequence.

In one form of known VSC, often referred to as a six switch converter, each valve comprises a set of series connected switching elements, typically insulated gate bipolar transistors (IGBTs) connected with respective antiparallel diodes. The IGBTs of the valve are switched together to electrically connect or disconnect the relevant AC and DC terminals, with the valves of a given phase limb typically being switched in anti-phase. By using a pulse width modulated (PWM) type switching scheme for each arm, conversion between AC and DC voltage can be achieved.

In another known type of VSC, referred to a modular multilevel converter (MMC), each valve comprises a chain-link circuit having a plurality of cells connected in series, each cell comprising an energy storage element such as a capacitor and a switch arrangement that can be controlled so as to either connect the energy storage element between the terminals of the cell or bypass the energy storage element. The cells are sometimes referred to as sub-modules, with a plurality of cells forming a module. The sub-modules of a valve are controlled to connect or bypass their respective energy storage elements at different times so as to vary over the time the voltage difference across the plurality of cells. By using a relatively large number of sub-modules and timing the switching appropriately the valve can synthesise a stepped waveform that approximates to a desired waveform, such as a sine wave, to convert from DC to AC or vice versa with low levels of harmonic distortion. As the various sub-modules are switched individually and the changes in voltage from switching an individual sub-module are relatively small a number of the problems associated with the six switch converter are avoided.

In the MMC design each valve is operated continually through the AC cycle with the two valves of a phase limb being switched in synchronism to provide the desired voltage waveform.

Recently a variant converter has been proposed wherein a chain-link of a series of connected cells is provided in a converter arm for providing a stepped voltage waveform as described, but each converter arm is turned off for at least part of the AC cycle. Thus the plurality of series connected cells for voltage wave-shaping are connected in series with an arm switch, referred to as a director switch, which can be turned off when the relevant converter arm is in the off state and not conducting. Such a converter has been referred to as an Alternate-Arm-Converter (AAC). An example of such a converter is described in WO2010/149200.

WO 2014/033155 discloses a method for controlling a modular converter, a controller for controlling a modular converter and a modular converter with such a controller.

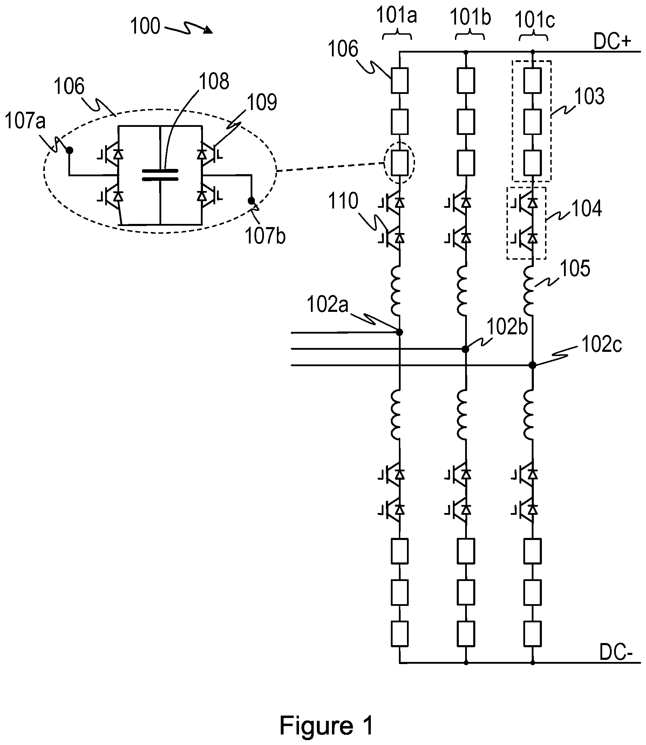

Figure 1 illustrates a known Alternate-Arm-Converter (AAC) 100. The example converter 100 has three phase limbs 101a-c, each phase limb having a high side converter arm connecting the relevant AC terminal 102a-c to the high side DC terminal DC+ and a low side converter arm connecting the relevant AC terminal 102a-c to the low side DC terminal DC-. Each converter arm comprises a circuit arrangement 103 of series connected cells, the arrangement 103 being in series with an arm switch 104 and inductances 105. It will be noted that figure 1 illustrates a single arm inductance but one skilled in the art will appreciated that the arm inductance may in practice be distributed along the arm between the AC and DC terminals.

The circuit arrangement 103 comprises a plurality of cells 106 connected in series. Each cell 106 has an energy storage element that can be selectively connected in series between the terminals of the cell or bypassed. In the example shown in figure 1 each cell 106 has terminals 107a, 107b for high-side and low-side connections respectively and comprises a capacitor 108 as an energy storage element. The capacitor 108 is connected with cell switching elements 109, e.g. IGBTs with antiparallel diodes, to allow the terminals 107a and 107b of the cell to be connected via a path that bypasses capacitor 108 or via a path that includes capacitor 108 connected in series. In the example illustrated in figure 1 each cell comprises four cell switching elements 109 in a full H-bridge arrangement such that the capacitor can be connected in use to provide either a positive or a negative voltage difference between the terminals 107a and 107b. In some embodiments however at least some of the cells may comprise switching elements in a half bridge arrangement such that the capacitor can be bypassed or connected to provide a voltage difference of a given polarity. The circuit arrangement 103 of such series connected cells can thus operate to provide a voltage level that can be varied over time to provide stepped voltage waveform for wave-shaping as discussed above. The circuit arrangement 103 is sometimes referred to as a chain-link circuit or chain-link converter or simply as a chain-link. In this disclosure the circuit arrangement 103 of such series connected cells for providing a controlled voltage shall be referred to as a chain-link.

In the AAC converter the chain-link 103 in each converter arm is connected in series with an arm switch 104, which will be referred to herein as a director switch, which may comprise a plurality of series connected arm switching elements 110. The director switch of a converter arm may for example comprise high voltage elements with turn-off capability such as IGBTs or the like with antiparallel diodes. When a particular converter arm is conducting, the chain-link 103 is switched in sequence to provide a desired waveform in a similar fashion as described above with respect to the MMC type converter. However in the AAC converter each of the converter arms of a phase limb is switched off for part of the AC cycle and during such a period the director switch 104 is turned off.

When the converter arm is thus in an off state and not conducting the voltage across the arm is shared between the director switch and the chain-link circuit. Compared to the MMC type VSC the required voltage range for the chain-link of each converter arm of an AAC type converter is thus reduced, with consequent savings in the cost and size of the converter.

As mentioned above the director switch 104 is typically formed from a plurality of series connected IGBTs. The IGBTs are typically connected in parallel with a balancing resistor for static voltage sharing between the individual switching elements of the director switch. In addition there may be a clamp snubber circuit located next to the IGBT to mitigate voltage overshoot during a turn-off transient event which comprises a capacitor and diode.

One issue that can arise in such an arrangement is a voltage imbalance across the switch elements of the director switch, e.g. the IGBTs and the associated clamp capacitors.

The present disclosure thus relates to methods and apparatus for control of voltage source converters that address issues of voltage imbalance.

The invention is defined in the appended independent claims. Preferred embodiments are defined in the dependent claims.

Thus, according to the invention, the timing of switching of the switching elements of the director switch is based on both the voltage level of the clamp capacitor associated with that switching element and also the degree of any voltage imbalance between the clamp capacitors or IGBTs. As will be explained in more detail below, in the event that there is no significant voltage imbalance the switching elements of the director switch may be switched substantially simultaneously. However if a significant voltage imbalance exists then those switching elements associated with clamp capacitors having a lower voltage level may be turned off earlier and/or turned on later than those switching elements associated with clamp capacitors having a higher voltage levels. In essence the timing of switching of the various switching elements of the director switch is controlled in accordance with how much voltage balancing is needed.

As will be described in more detail below various techniques for voltage balancing have been previously proposed, but such techniques may not be appropriate for configurations where the director switch unit includes a clamp capacitor connected in parallel with a switching element.

In some embodiments each director switch unit may further comprise a self-powered floating power supply configured to draw power, in use, from the clamp capacitor. The use of a floating power supply to draw power from the clamp capacitor is a complicating factor that further means the previously proposed techniques for voltage balancing may not be appropriate.

The method comprises turning-off the semiconductor switching elements of the director switch units, i.e. to transition the director switch from a fully conducting state (all switching elements turned on) to a fully non-conducting state (all switching elements turned off).

The method may therefore involve, at a first turn-off time, turning off a first set of semiconductor switching elements. The first set of semiconductor switching elements comprises the semiconductor switching element having the associated clamp capacitor having the lowest voltage level and any semiconductor switching element having an associated clamp capacitor with a voltage level within a predetermined range of the lowest voltage level. The first set may therefore contain just a single semiconductor switching element that switching element is associated with a clamp capacitor with a voltage which is significantly lower than all the others. In some instances however the first set of switching elements turned off at the first turn off time may contain a plurality of switching elements. If all the clamp capacitor voltages are within the predetermined range, i.e. there is no significant voltage imbalance, then the first set may contain all the switching elements of the director switch.

In the event that not all semiconductor switching elements are turned off as part of the first set at the first turn-off time, the method may comprise progressively turning off the switching element having the associated clamp capacitor having the lowest voltage level of all switching elements that are still on at the earliest of (i) a voltage across that semiconductor switching element reaching a level which is within a predetermined range of the voltage level of the clamp capacitor associated with that semiconductor switching element or (ii) the voltage across the director switch reaching a limit based on the number of semiconductor switching elements that are presently turned off.

In other words a semiconductor switching element is turned off once the voltage across that switching element reaches the level of the associate clamp capacitor voltage. However the semiconductor switching element with the lowest clamp capacitor voltage level may be turned off before that point if the number of switching elements turned off is not sufficient to support the voltage across the whole director switch.

In VSC according to the invention, the director switch is connected in series in a converter arm with a chain-link circuit for voltage wave-shaping. The method comprises modulating a voltage generated by the chain-link circuit during the transition the director switch from a conducting state to a non-conducting state. The chain-link voltage is modulated to increase the rate of voltage increase across the director switch after a given semiconductor switching element has been turned off. Additionally or alternatively to controlling the turn-off of the director switch in some embodiments the method may comprise turning-on the semiconductor switching elements of the director switch units to transition the director switch from a fully non-conducting state to a fully conducting state.

The director switch may be controlled so as to be fully conductive at an on-time. However the transition from being fully non-conducting may in some instances start before this on-time. Thus in some embodiments starting at a first transition start time (i.e. a first possible start time for the transition) and continuing to the on-time, the method may involve monitoring the voltage levels of the clamp capacitors to determine whether the difference between a highest and a lowest voltage level exceeds a predetermine threshold, i.e. monitoring for any significant voltage imbalance. In the event that (i) this monitored difference does exceed the threshold and (ii) a voltage across the director switch is low enough to allow turn on of a semiconductor switching element, the method may comprise turning on the semiconductor switching element associated with the clamp capacitor having the highest voltage level.

As noted above, by the on-time the director switch should be fully conducting and thus the method may involve, at the on-time, turning on all semiconductor switching elements that are presently turned off.

In the event that a semiconductor switching element is turned on before the on-time, the method may comprise determining whether a voltage level of a clamp capacitor associated with a semiconductor switching element that is still turned off exceeds a voltage value for the clamp capacitors associated with the semiconductor switching elements that have been turned on and, if so, then provided that a voltage across the director switch is low enough to allow turn on of a semiconductor switching element the method comprises turning said semiconductor switching element on. The voltage value for the clamp capacitors associated with the semiconductor switching elements that have been turned on may comprise one of: a highest voltage level and an average voltage level, or any other combination that reflects the level of unbalance.

In other words if a first semiconductor switching element which is still turned off (and thus has a voltage difference across it) has a clamp capacitor voltage level which exceed the minimum or average voltage of the clamp capacitors of those switching elements that have been turned on (and thus have no voltage difference across them) then the first semiconductor switching element may be turned on (provided sufficient switching elements remain off to support the voltage across the whole director switch) to avoid any increase in voltage imbalance.

As noted above in VSCs according to the invention the director switch is connected in series in a converter arm with a chain-link circuit for voltage wave-shaping. The method comprises modulating a voltage generated by the chain-link circuit during the transition of the director switch from the non-conducting state to the conducting state. The chain-link voltage is modulated to decrease the rate of voltage decrease across the director switch after a given semiconductor switching element has been turned on.

In some embodiments however the method of voltage balancing may be applied during the turn-off of the director switch, i.e. the transition from fully conducting to fully non-conducting, but once the director switch is fully non-conducting, and the voltage across the director switch reaches a peak level, the chain-link in series with the director switch may be modulated to maintain the voltage across the director switch at this level until just before the director switch is turned on to become fully conducting. Thus the method may comprise modulating a voltage generated by the chain-link circuit during a period in which the director switch is off such that a voltage across the director switch increases during a first period to a peak value and then is maintained at substantially said peak value during a second period.

Aspects of the present invention also provide a control apparatus for controlling a director switch of a voltage source converter having a plurality of series connected director switch units each comprising a semiconductor switching element and an associated clamp capacitor connected across the semiconductor switching element, wherein the control apparatus is configured to:
receive an indication of the voltage level of the associated clamp capacitors of the director switch units; and
generate switching control signals for controlling switching the semiconductor switching elements of the director switch units to transition the director switch between conducting and non-conducting states;
wherein the timing of switching of a semiconductor switching element is based on the voltage level of the associated clamp capacitor and the degree of any voltage imbalance between the clamp capacitors of the director switch units;
wherein the control apparatus is further configured to generate:
   switching control signals for turning-off the semiconductor switching elements of the director switch units to transition the director switch from a conducting state to a non-conducting state so as to turn the director switch off; and
   a modulation control signal for controlling modulation of modulating a voltage generated by a chain-link circuit for voltage wave-shaping connected in series with the director switch during a period that the director switch is transitioning from a fully conducting state to a fully non-conducting state;
   wherein the modulation control signal is generated so as to modulate the chain-link voltage to increase the rate of voltage increase across the director switch after a given semiconductor switching element has been turned off.

The control apparatus may be arranged to operate the director switch according to the method of any of the variants described above.

The control apparatus may be configured to receive, from each director switch unit, repeated measurements of the voltage level of the associated clamp capacitor throughout a period of a director switch transition as said indication of the voltage level of the associated clamp capacitors of the director switch units. In order words data about the measured voltage level of the clamp capacitors may be provided by each director switch unit to the control apparatus so that the control apparatus can monitor the evolution of the voltages of the clamp capacitors of the director switch units. Such measurements may be made and communicated relatively continuously, at least during the period before and during a transition of the director switch where voltage balancing may be applied.

In some instances however it may be preferred to avoid the need for communicating so much data. Thus in some embodiments the control apparatus may be configured to receive, from each director switch unit, a measurement of the voltage level of the associated clamp capacitor prior to a director switch transition as said indication of the voltage level of the associated clamp capacitors of the director switch units. In such a case the switching control signals generated by the control apparatus may comprise a control signal for a director switch unit to turn on or off at a particular clamp voltage level, i.e. an activation level. In some embodiments the control apparatus may be configured to predict a voltage evolution for the voltages of the director switching units based on said received measurement of the voltage level of the associated clamp capacitors of the director switching units and to generate the switching control signals based on the predicted voltage evolution. The prediction may be based on a single measurement made before the relevant transition. In some embodiments however the control apparatus may be configured to update the predicted voltage evolution based on one or more measurements of the voltage level of the clamp capacitors of the director switching units received during the period of a director switch transition.

Aspects also relate to a converter arm apparatus for a voltage source converter comprising: a director switch comprising a plurality of series connected director switch units each comprising a semiconductor switching element and an associated clamp capacitor connected across the semiconductor switching element; and a control apparatus as described above.

Each director switch unit may further comprise a floating power supply configured to draw power, in use, from the clamp capacitor.

The converter arm apparatus comprises the chain-link circuit for voltage wave-shaping in series with the director switch.

Aspects also relate to a voltage source converter comprising at least one phase limb having two converter arms, each converter arm comprising a converter arm apparatus as described.

The invention will now be described by way of example only with respect to the accompanying drawings, of which:
Figure 1 illustrates one example of an alternate-arm-converter (AAC) type voltage source converter (VSC);
Figure 2 illustrates one example of circuitry associated with a switching element of a director switch of a VSC;
Figure 3a and 3b illustrate voltage and switching control waveforms respectively for first and second techniques for voltage balancing of a director switch;
Figures 4a and 4b illustrate results of simulating the first and second techniques illustrated in figures 3a and 3b;
Figure 5 illustrates voltage and switching control waveforms respectively for a technique for voltage balancing of a director switch according to an embodiment of the invention;
Figures 6a and 6b illustrate further voltage and switching control waveforms for the method according to an embodiment of the present invention;
Figure 7 illustrate results of simulations using a voltage balancing technique according to an embodiment;
Figure 8 illustrates voltage and switching control waveforms for voltage balancing of a director switch according to the invention; and
Figure 9 illustrates director switch control apparatus according to an embodiment.

As mentioned above some types of voltage source converter (VSC), such as the alternate-arm-converter (AAC) illustrated in figure 1, comprise an arm switch 104 in a converter arm of the VSC for switching the converter arm between being conductive or non-conductive during the power cycle. Such an arm switch is referred to herein as a director switch. To provide the necessary voltage rating the director switch will typically comprise a plurality of switching elements 110 such as IGBTs connected in series.

In use the director switch of a converter arm may be turned off for part of the power cycle. In the AAC type converter, where each converter arm comprises a director switch 104 in series with a chain-link circuit 103 for voltage wave-shaping, the director switch of a converter arm is turned off at a desired point in the power cycle. In normal operation the director switch is turned off (or on) at a point when the chain-links of the converter arms of the phase limb are providing suitable voltages such that the voltage across the director switch being turned off (or on) is substantially zero. The two converter arms of a phase limb are also controlled together so that in normal operation there is substantially no current through the director switch at the point at which it is turned-off.

Once turned off the voltage across the director switch increases as the voltage at the AC terminal of the phase limb varies. To ensure correct voltage sharing between the various switching elements of the director switch there is typically a balancing resistor connected in parallel with each switch element. Additionally there is typically a clamp snubber circuit comprising at least a capacitor and a diode to mitigate voltage overshoot during a turn-off transient event.

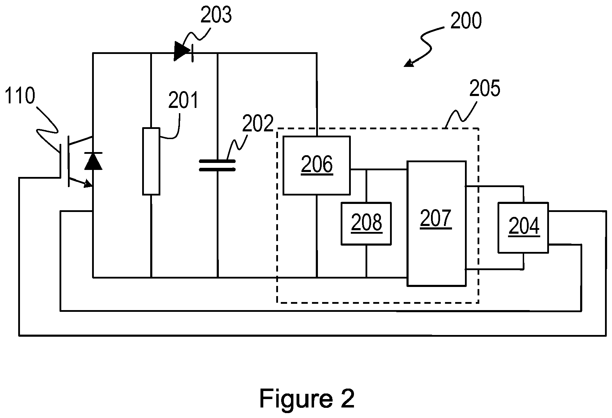

Figure 2 illustrates one example of a director switch unit 200 associated with an individual switching element 110 of a director switch. As used herein the term director switch unit shall be used to refer to an individual switching element 110 and its associated circuitry. The switching element 110 comprises a semiconductor switching element such as an IGBT with antiparallel diode. In parallel with the IGBT 110 is a balancing resistor 201. A clamp snubber circuit comprises clamp capacitor 202 connected in parallel with the IGBT 110 via snubber diode 203. The IGBT 110 is controlled by local control electronics 204 including a suitable gate driver.

It will be appreciated that figure 2 only illustrates those components that are of interest for the present disclosure and in practice there may be many additional components and circuitry associated with the individual switching elements of the director switch such as crowbar circuits or surge arrestors for example.

Recently it has been proposed that the local control electronics may be powered by a floating power supply 205 that draws power from the capacitor 202 that forms part of the clamp snubber circuit. In the example illustrated in figure 2 the floating power supply 205 thus comprises a first DC-DC 206 converter for converting from the high voltage across the IGBT/clamp capacitor 202 to an intermediate voltage and a second DC-DC converter 207 for converting to a low voltage suitable for powering the control electronics 204, e.g. gate driver, for the IGBT 110. The floating power supply may also comprise some long term energy storage 208 such as a suitable capacitor arrangement for providing power during fault events where there may temporarily be no voltage across the director switch.

The floating power supply 205 typically exhibits a constant power load characteristic, due to the control loop of the DC-DC converters 206 and 207 which keep the output voltage constant regardless of any variation in input voltage. Therefore, if the load current demanded by the gate driver of the control electronics 204 remains constant, as it is typically the case, the input current demanded by the floating power supply 205 will change to keep a constant product of voltage V and current I, i.e. a constant V*I product. Thus if the input voltage to the floating power supply, i.e. the voltage across the clamp capacitor 202, increases or decreases, the input current will proportionally decrease or increase respectively.

It has been appreciated that this effect can contribute to any imbalance in voltage across the IGBTs and corresponding clamp capacitors of the director switch units of the director switch. If the voltage across a given IGBT 110 or its associated clamp capacitor 202 decreases then a greater current will be demanded by the floating power supply, which will contribute to a further voltage decrease. Conversely if the voltage across the IGBT/clamp capacitor is increasing then the input current demanded by the floating power supply will decrease, thus contributing to a further increase in the voltage across the IGBT/clamp capacitor.

Due to the relatively small capacitance of the clamp capacitor 202, which may for instance be of the order of 1 µF, this effect may be significant. It has been found that for a director switch formed from director switch units which include a floating power supply arranged to take power from the clamp capacitor, then any component mismatch between the director switch units, e.g. between the voltage balancing resistors associated with different IGBTs, or any difference in the instantaneous voltage across the director switch units can lead to a relatively large voltage imbalance being generated over a number of cycles of VSC operation. This is especially the case if the floating supply is 205 charging the long term storage 207, when the power drawn by the floating supply is comparatively greater than that drawn during normal operation.

As mentioned the effect of the floating power supply can be to exacerbate any voltage difference with the final result that an excess voltage is developed across some director switch units whilst there is a loss of power for the control electronics of others.

Various techniques for dealing with voltage imbalances across the series connected elements of a director switch have been proposed.

In a first technique, which has been proposed for the AAC type converter, the chain-link of a converter arm is controlled so as to modulate the voltage across the director switch of that converter arm to be substantially constant throughout most of the period during which the director switch is off. This is in contrast to the usual approach where the voltage across the director switch may vary throughout substantially the whole of the off-state period.

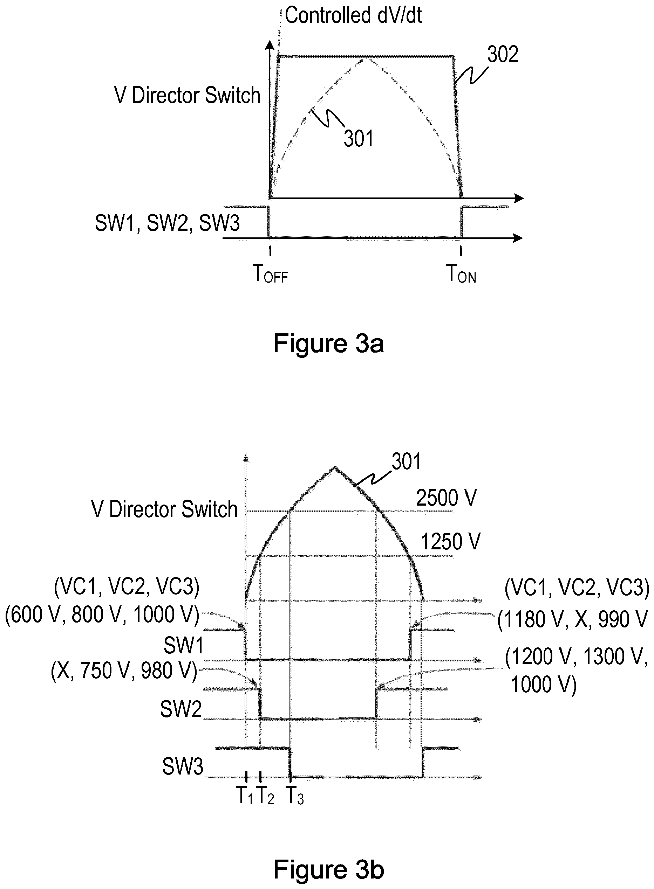

Referring back to figure 1 it will be appreciated that the director switch 104 of a converter arm is turned off for part of the power cycle of a phase limb so that the converter arm is non-conducting. As a simple example the director switch 104 of the high side converter arm of a phase limb may be turned on during the positive half of the cycle, with the chain-link of the high side converter arm providing wave-shaping, and the director switch of the high side arm may be turned off for the negative part of the cycle. In this simple example the high side director switch is thus turned off when the voltage at the AC terminal is at the mid-point voltage, e.g. zero volts. At this point the voltage generated by the high-side chain link will be equal to V_{DC}/2 - where V_{DC} is the pole-to-pole DC voltage - and thus there will initially be no voltage across the high-side director switch. Typically the high-side chain-link would be maintained at this voltage level through the entire period that the high-side director switch is off so as to minimise the voltage stress across the director switch. The voltage across the director switch would thus rise throughout the cycle as the voltage at the AC terminal dropped to the maximum negative value of -V_{DC}/2 and then drop again as the voltage at the AC terminal increased back to zero. This is illustrated in figure 3a by dashed plot 301. It will be appreciated however that this is just one example of operation of an AAC type converter. In other examples the director switches of the converter arms may both be on at the same time for part of the power cycle, in a so called overlap mode of operation. In any case the director switch of a converter arm may be turned off at a given point in the power cycle with the relevant chain-link producing a voltage such that there is initially no voltage across the director switch and during the period it is turned-off the voltage across the director switch may vary in a similar fashion to that illustrated in figure 3a.

In the first technique for voltage balancing the high-side director switch is turned off at an appropriate point in the power cycle at a time T_{OFF}. At this point the voltage of the high-side chain link is such that the voltage across the director switch is substantially zero. Once the director switch is off however the voltage of the high-side chain link is rapidly modulated so that the voltage across the director switch ramps, at a constant ramp rate dV/dt to the peak voltage difference, as illustrated by plot 301. The voltage of the high-side chain link is then modulated so as to maintain a constant voltage across the director switch as the voltage at the AC terminal varies. In effect the voltage of the high-side chain-link is modulated in synchronism with the voltage of the low side chain-link providing voltage wave shaping for the active converter arm. Just before the high side director switch is turned back on at a time T_{ON} the voltage of the high-side chain link can be varied to ramp the voltage across the director switch down to zero such that the director switch turns on with no voltage across it. The ramp of the voltage across the director switch prior to turn on of the director switch has the same ramp rate, but opposite sign, to that following turn off. This results in the voltage waveform for the director switch for the off state period being effectively a square wave with a largely constant voltage across the director switch whilst it is off and only short periods of controlled voltage gradient. For a conventional VSC this can aid in keeping the various director switch units balanced.

In a second technique for voltage balancing the various switch elements of the director switch may be turned off in a staggered fashion in a desired sequence, as illustrated in Figure 3b, rather than simultaneously as was the case in figure 3a. Figure 3b illustrates for the purposes of illustration the switching sequence for a director switch with just three director switch units, i.e. three switching elements SW1, SW2 and SW3. It will be appreciated however that in practice there may be many more switching elements forming a director switch. At a time T₁ when the director switch is to be turned off one of the switching elements of the director switch is turned off. The relevant switching element to be turned off is based on an indication of the present voltage level of the relevant clamp capacitor. In the example illustrated in figure 3b switching unit SW1 has the lowest voltage level and is turned off first.

In this technique the chain-link of the converter arm maintains a voltage level that minimises the voltage across the director switch and thus the voltage across the director switch follows plot 301 as described above. Initially therefore the voltage across the director switch is relatively low and at a level that can be withstood by a single switching element. As a particular threshold is reached another switching element is turned off at time T₂ to withstand the increasing voltage with the relevant switching element again being selected based on the lowest clamp capacitor voltage. This sequence is continued with the switching elements being turned off progressively as thresholds are reached based on which switching unit has the lowest voltage. This means that as the voltage across the director switch is ramping up the switching elements are turned off in sequence with those with lower clamp capacitor voltages being turned on earlier and thus exposed to a voltage difference across the switching unit for longer and hence subject to a greater increase in voltage. The turn-off process of the director switch thus has an extended transition from being fully conductive, i.e. all switching elements being on, to be being fully non-conductive, i.e. all switching elements turned off.

The turn on transition from being fully non-conducting to being fully conducting operates a similar sequence but in reverse with the switching units with the highest clamp capacitor voltages being turned on first. Thus a first switching element may be turned on when the voltage across the director switch drops to a threshold level and the switching unit selected is that with the highest voltage of the clamp capacitor. In the example of figure 3b switching element SW2 turns on first followed by SW1 and SW3 as the various thresholds are reached.

This approach of sequencing the thus provides a degree of voltage balancing as each cycle the switching units with a lower clamp capacitor voltages will be charged to a greater extent that those with a higher clamp capacitor voltage.

It has been appreciated however that the first and second techniques discussed above have shortcomings, especially if used with director switching units such as illustrated in figure 2 where a floating power supply draws power from the clamp capacitor.

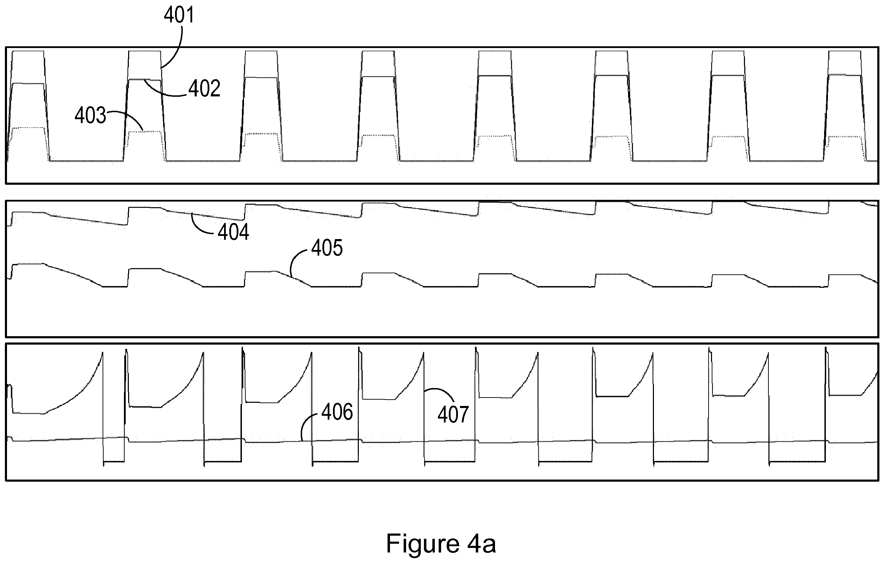

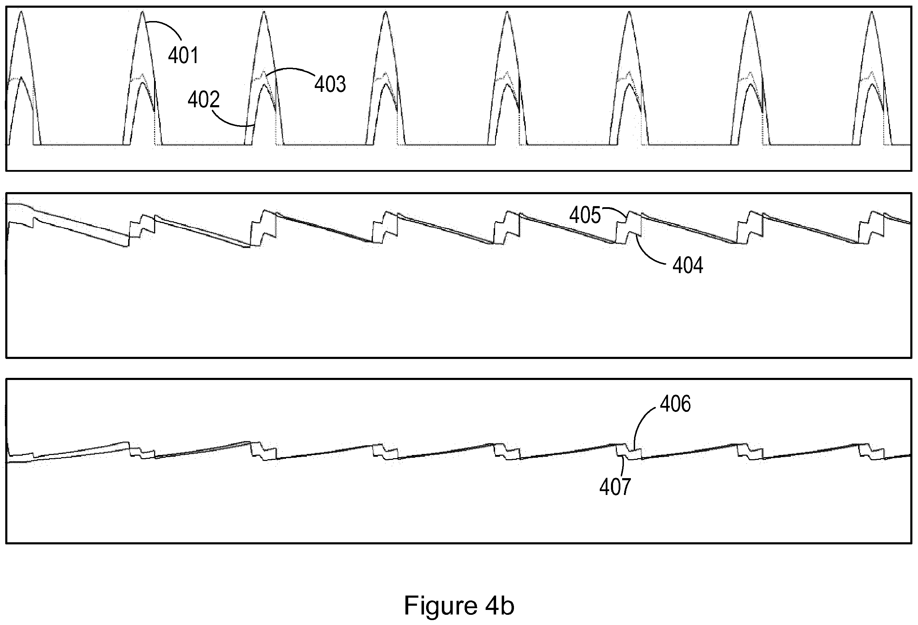

Figures 4a and 4b show the results of simulation of a director switch having a voltage imbalance between the switching elements and operated according to the first and second techniques discussed above respectively. The director switch was simulated with just first and second director switching units, with the first switching unit having a higher starting instantaneous voltage than the second switching unit, and the simulation covered several power cycles of the converter arm. The starting voltage of the clamp capacitor of the first switching unit was simulated at 1500V with the capacitor of the second switching unit at 500V. The floating power supply was simulated with a power draw of 22W.

Figure 4a shows the simulated waveforms for the director switch subject to the first modulation technique, i.e. a square wave voltage waveform being applied across the director switch during the off state. The top plot of figure 4a illustrates the voltage waveform 401 across the whole director switch and the voltage waveforms 402 and 403 across the switching elements of the first and second switching units respectively. The middle plot shows the voltages 404 of the clamp capacitors of the first and second switching units respectively. The lower plot illustrates the current demand 406 of the floating power supply of the first switching unit and the current demand 407 of the floating power supply of the second switching unit.

It can be seen that the initial starting voltage difference quickly leads to an increasing voltage imbalance and the system quickly becomes unstable. This suggests that such a modulation scheme may not be suitable for use with switching units of a director switch with a clamp capacitor, and especially for VSC designs where the switching units of thje director switch include a floating power supply which draws power from the clamp capacitor.

Figure 4b illustrates the same plots, and uses the same reference numerals for the voltage waveforms, but simulates the turn off and on of the switching elements of the director switch in a staggered fashion in a sequence. It can be seen that over this simulated time scale in the first cycle the second switching unit is turned on first (before the first switching unit) and is turned on last (after the first switching unit). For each subsequent cycle however the second switching unit turns off before the first switching unit but then turns on before the first switching unit. This approach thus achieves stable operation after a number of cycles. However, the IGBTs are never perfectly balanced, the voltage difference between capacitors is always instantaneously different and the ripple across them is greater than if no special modulation was used. This is due to two reasons: the balancing strategy is always acting regardless of the level of any unbalance of the clamp capacitors; and the switching instances, derived from switching at predetermined steps, are not the optimum for a fast and effective balancing effect.

Embodiments of the present invention thus relate to methods and apparatus for voltage balancing that at least mitigate some of the above mentioned issues and which can be used satisfactorily with switching units having a floating power supply that draws power from the clamp capacitor.

In a method according the present invention a director switching unit of the director switch may be turned off (and/or turned on) at times determined by the present voltage level of the clamp capacitor of the director switch unit compared to the voltage level of the other switching units. However unlike the staggered turn off described above with respect to figure 3b, where the times/voltage thresholds of the sequence are fixed, in the method of the present invention the timing of when the various director switch elements turn off or on may vary based on the present clamp capacitor voltage level and the degree of any voltage imbalance.

Thus if there is no significant voltage imbalance between the director switch units of the director switch then all such director switch units may be turned off and/or turned on simultaneously. It is only if there is a significant voltage imbalance between the clamp capacitor voltages of at least some of the director switch units that the relevant turn off/turn on times vary and the turn off or turn on of the director switch becomes staggered.

In some embodiments the turn off of the director switch units are controlled in this manner. In this case at a first time T₁ corresponding to the start of period where the director switch should be off, at least one of the director switching elements is turned off. The director switch unit with the lowest clamp capacitor voltage is identified and it, and any switching units at substantially the same voltage and/or within a predefined voltage range of the lowest clamp capacitor voltage, may be turned off. Thus, as mentioned if there is no significant voltage imbalance between the director switch units then all switching elements of the director switch units may be turned off simultaneously. However if there is a voltage imbalance then the switching unit with the lowest clamp capacitor voltage and any switching units with clamp capacitors voltages that do not differ significantly in voltage from this lowest voltage are turned off together and the remaining switching unit(s) remain on. The voltage across the director switch will thus be shared across those director switch units that have been turned off and the voltage of the clamp capacitors of such director switch units will tend to increase. Subsequently, subject to the general constraint that the voltage across any one director switch unit should not exceed a safe operating level and that there should be sufficient switching elements of the director switch in the off state to support the voltage across the director switch, then further director switch units may be turned off when the voltage across that switching element becomes substantially equal to the voltage level of the associated clamp capacitor. This should mean that the voltage of the clamp capacitors of the director switch units that are already off have risen to the same level of the relevant director switch unit that is still on. In this way the director switch units may be turned off progressively where, at the point of turn off the clamp capacitor voltage of the relevant director switch unit is at the same level or within a defined range of other director switch units also being turned off or already off.

Turn on of the director switch units may additionally or alternatively be controlled in a similar fashion. The method may be arranged such that all director switch units be turned on by an on-time T_{ON} when the director switch is required to be fully conducting (but at least one director switch units be kept non-conducting until such an on-time). Before this on-time however one or more director switch units may be turned on earlier if any difference between voltages of the clamp capacitors of the director switch units becomes significant, for instance if the voltage difference between the clamp capacitor voltages of two different switching units exceeds a predefined threshold. Therefore if there is substantially no voltage imbalance between the director switch units as the voltage across the director switch ramps down then no director switch units may be turned on early and all director switch units may be turned on simultaneously at the time T_{ON}. However, starting from a first transition time or a transition start time, e.g. during the period of ramp down of voltage across the director switch, if a significant voltage imbalance exists then at least one director switch unit may be turned on early.

Subject to the constraint that sufficient switching elements remain off to support the voltage across the whole director switch, the director switch unit with the highest clamp capacitor voltage is identified and it, and possibly any director switch units at substantially the same voltage and/or within a predefined voltage range of the highest clamp capacitor voltage, may be turned on. This will result in the voltage across the director switch being shared amongst the director switch units that remain off, increasing the voltage of the relevant clamp capacitors and reducing the rate of voltage drop. Subsequently, again subject to the general constraint that the voltage across any one director switch unit should not exceed a safe operating level and that there should be sufficient switching elements of the director switch in the off state to support the voltage across the director switch, then further director switch units may be turned on if their voltage is substantially greater than a voltage value for the switching unit(s) that have already been turned on. This voltage value in some embodiments may the lowest clamp capacitor voltage of any of the director switch units that have been turned on but in other embodiments it could be an average voltage value or some other derived voltage value.

This method thus aims to balance the clamp capacitors by switching IGBTs when and as long for it is needed. As noted it only results in a staggered turn on or turn off of the switching elements if and when there is sufficient imbalance between the clamp capacitors. Consequently, during normal operation the turn off or turn on sequence is not pre-determined, but based on the instantaneous measurement of the clamp capacitor voltages. It should be noted that this technique might not be used in an abnormal event that may require a fast operation of the director valve.

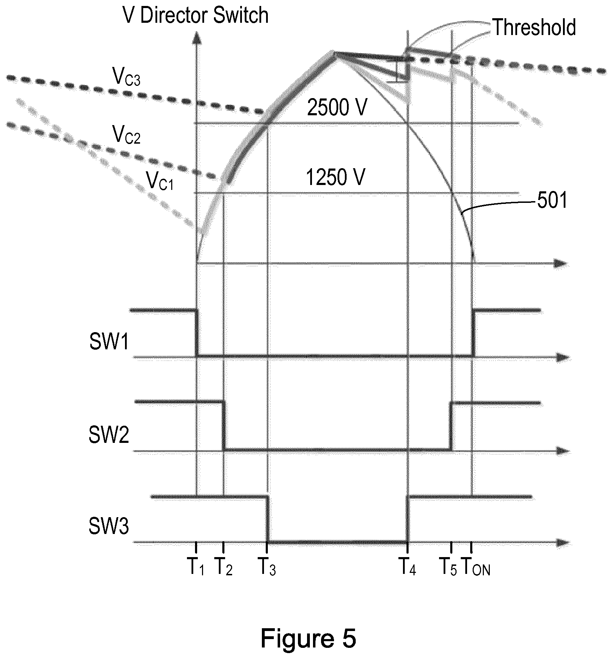

Figure 5 illustrates the principle of operation, again in relation to a director switch assumed to have three switching elements SW1, SW2 and SW3 of first, second and third director switch units respectively. Figure 5 illustrates how the voltage waveform 301 across the director switch during the period that the director switch is non conducting as described previously with reference to figures 3a and 3b. Figure 5 also illustrates how the voltages Vci, V_{C2} and V_{C3} of the clamp capacitors of the first, second and third director switch units respectively vary.

As described above at time T₁ the director switch is switched to become non-conducting. At this time the voltage V_{C1} of the first director switch unit is the lowest and is significantly lower than voltages V_{C2} and V_{C3}. Thus switch SW1 is turned off at this point. Thus the voltage across the director switch, which starts rising, is initially applied to the first switching unit only and the voltage V_{C1} starts to increase. At a time T₂ the voltage V_{C1} reaches the present level of voltage V_{C2} and thus switch SW2 is then turned off. The timing of the turn off of this switching element and the voltage level at which it occurs are not predetermined and depend on the actual voltages V_{C1} and V_{C2}. The voltage across the director switch is thus now shared between the first and second director switch units, which start on the same voltage level. The voltage of both clamp capacitors thus rises until the voltage level V_{C3} is reached at time T₃ at which point switch SW3 is turned off At this point all director switch units have been turned off

Subsequently the director switch will be turned on again at a time T_{ON}. Before then, as the voltage across the director switch drops the voltages of the clamp capacitors are monitored to determine if any voltage imbalance exists above a certain predetermined threshold. In this example at a time T₄ the difference between the highest capacitor voltage and the lowest capacitor voltage exceeds a predetermined threshold and thus the director switch unit with the highest capacitor voltage, SW3 in this example, is turned on. In fact in this example the voltage imbalance between the capacitors greater than the threshold exists at a time before T₄ but before this time the voltage across the whole director switch is such that none of the director switch units can be turned-on, i.e. all director switch units need to remain off to support the voltage. It is at time T₄ that the voltage across the whole director switch is low enough that one of the director switch units can be turned on. As, at this point, as voltage imbalance greater than the threshold exists, the control turns on switch SW3.

Once switch SW3 is turned on the voltage across the director switch is shared between the remaining switches in the off state, i.e. SW1 and SW2. This results in a jump in voltage across these switching elements. The voltage across these switches in the off state may then be monitored against a voltage level derived from the switch(es) that are on, in this case switch SW3. Again however a switching element of a director switch unit will only be turned on when the remaining off state switching elements are able to support the voltage across the director switch. In the example illustrated in figure 5 switch SW2 is turned on at a time T₅ once the voltage level has dropped sufficiently, thus resulting in a jump in voltage across the remaining off switch, i.e. SW1. SW1 is then maintained off until the on time T_{ON} when it is turned on.

It will be appreciated that this strategy for balancing the voltages during the period when the voltage across the director switch is decreasing, i.e. a period of negative voltage slope, can, in the event of significant voltage imbalance, result in voltage waveforms across at least some switching elements/clamp capacitors of a director switching unit that exhibit relatively sudden step changes. In this sense the modulation strategy applied during the negative voltage slope across the director switch is not as smooth as the modulation strategy applied during the period of positive voltage slope across the director switch.

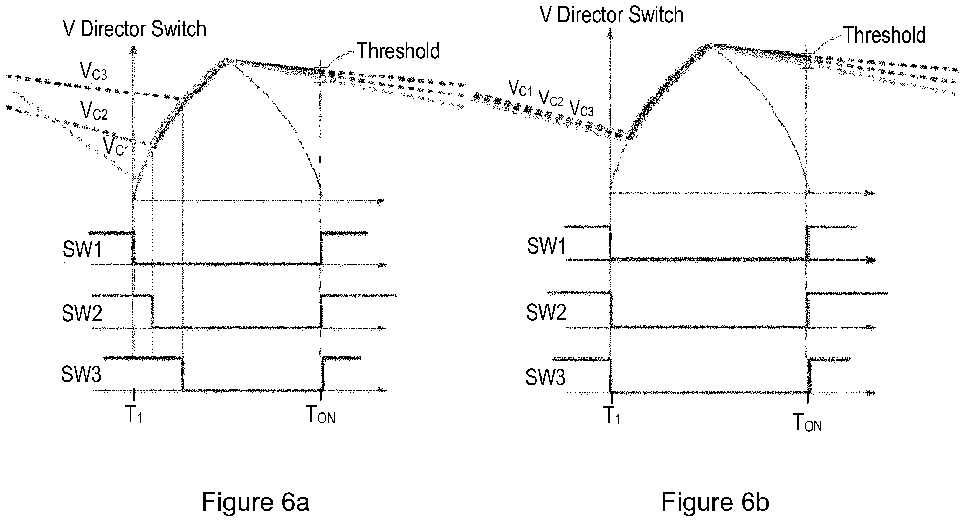

As noted however if there is no significant voltage imbalance between the clamp capacitor voltages of the director switch units then the switching elements of the director switch units may be operated at the same time. For example figure 6a illustrates an example where the clamp capacitor voltages Vci, V_{C2} and V_{C3} of the director switch units have a significant imbalance before turn off of the director switch at a time T₁ and thus the relevant switching elements are turned off in a staggered fashion as described with reference to figure 5, but during the falling voltage across the director switch the voltages of the clamp capacitors stay within a predefined limit of one another and thus all the switching elements remain off until the time T_{ON} when they are turned on simultaneously. Figure 6b illustrates another example where the voltages of the clamp capacitors do not exhibit any significant imbalance at the point of turn off of the director switch and thus all the director switch units are turned off simultaneously at time T₁.

In some embodiments the techniques described above may be applied as described above during the period of positive voltage slope across the director switch, but it may be preferred not to apply the techniques during the negative voltage slope across the director switch. In other words if any voltage imbalance exists during the period of positive voltage slope then the control may be configured to delay the turn off of one or more switching elements to provide voltage balancing, resulting in a staggered turn-off of the switching elements. However the control may be configured so that the switching elements are subsequently turned back on simultaneously. As mentioned above turning on switching elements of the director switch earlier than the on time may result in a less smooth voltage transition. According to the invention the voltage of the chain link is modulated during this period to try to maintain the balance of clamp capacitor voltages as will be described in more detail below.

To demonstrate the operation of the technique, a director switch having a voltage imbalance between the switching elements and operated according to the present method was simulated. The director switch was simulated according to the same conditions as the simulations discussed with reference to figures 4a and 4b, i.e. with just first and second switching units, with the first switching unit having a higher starting instantaneous voltage than the second switching unit. The starting voltage of the clamp capacitor of the first switching unit was simulated at 1500V with the capacitor of the second switching unit at 500V. The floating power supply was simulated with a power draw of 22W.

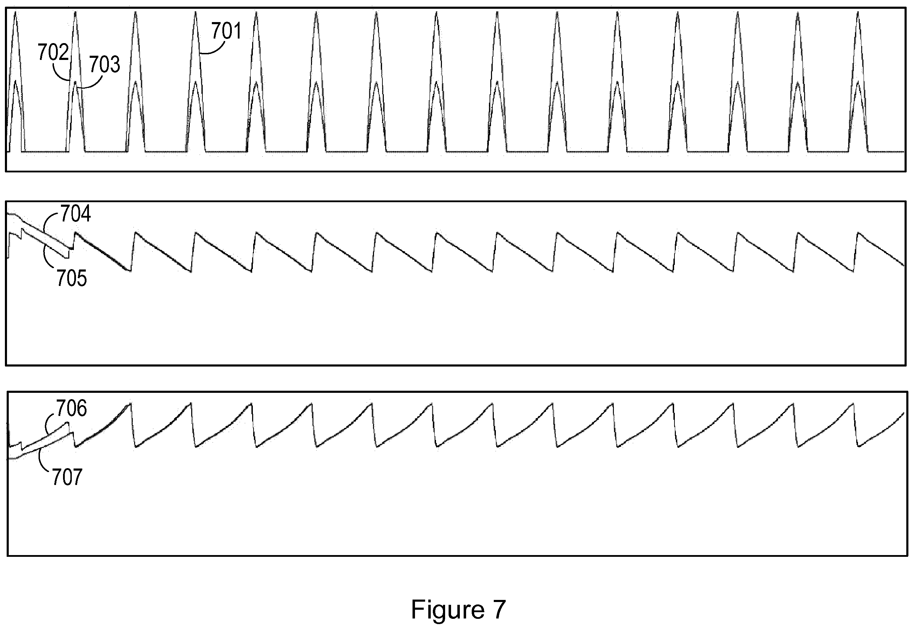

The results of the simulation are shown in figure 7. The top plot shows the voltage waveform 701 across the whole director switch and the voltage waveforms 702 and 703 across the first and second director switch units respectively. The middle plot shows the voltages 704 and 705 of the clamp capacitors of the first and second switching units respectively. The lower plot illustrates the current demand 706 of the floating power supply of the first switching unit and the current demand 707 of the floating power supply of the second switching unit.

It can be seen that in the voltage of the clamp capacitor of the second switching unit starts lower and the second switching unit is thus turned off before the first switching unit. After only a few cycles however the initial imbalance is quickly compensated, and a condition of balance is achieved across both IGBTs and clamp capacitors.

To further prove the validity of the technique, further simulations have been performed for director switches having a greater number of switching elements, with voltage imbalances and again good balance was achieved quickly and maintained. Further simulations have also shown good responses for other component mismatch situations, such as clamp capacitors or sharing resistors having different values, and power supplies drawing different instantaneous power levels.

In the examples discussed above it has been assumed that the chain-link of the relevant converter arm is controlled to maintain a substantially constant voltage during the period that the director switch is off and the converter arm non conducting. Thus the voltage waveform across the whole director switch is principally due to the voltage variation at the AC terminal/other converter arm.

According to the invention however the chain-link of the converter arm is controlled so as to vary the shape of the voltage supported by the director-switch in the off-state. The voltage waveform experienced by the director switch may be modified such that, when combined with the switching strategy, the balancing effect across the clamp capacitors can be improved.

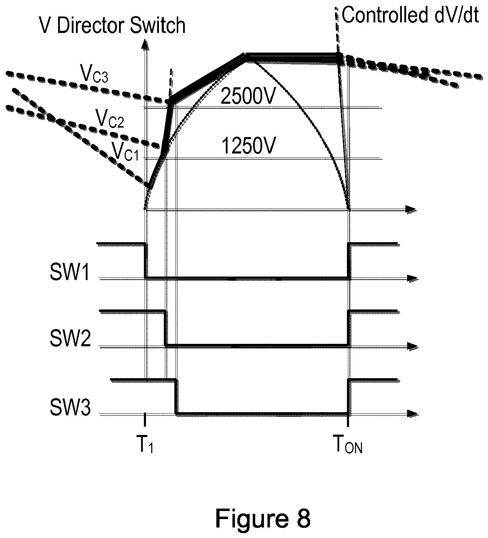

For example figure 8 illustrates one possible example of an alternative voltage modulation that may be applied. At the time T₁ when the director switch is turned off the voltage of the chain-link is controlled so that there is no voltage across the director switch as is conventional. The switching strategy described above may be implemented so that switching element SW1 is turned off first because the voltage V_{C1} of the relevant clamp capacitor is significantly lower than that of the other clamp capacitors. Once the voltage V_{C1} has increased to equal V_{C2} switching element SW2 is also turned off At this point the chain-link voltage is controlled such that the rate of voltage increase across the director switch is faster than normal, to facilitate the fast balancing of the clamp capacitor of the second director switch unit. Once the voltages V_{C1} and V_{C2} reach the voltage V_{C3} the rate of increase may be reduced until the peak voltage is reached. Again there will be the general constraint that the number of switching elements turned off must be sufficient to support the voltage across the director switch.

Additionally or alternatively the voltage may be modulated for the falling part of the voltage waveform. For example figure 8 illustrates that during the (normally) falling part of the voltage waveform, the voltage is maintained at its peak value, for as long as possible, to keep the clamp capacitors charged and balanced. The voltage is then ramped down at a constant rate just before the director switch turns on at a time T_{ON} with all switching elements being turned on simultaneously.

It will be appreciated however that any other wave-shape profile, combined with a suitable switching sequence of the director valve IGBTs could also be chosen depending on the particular condition of the clamp capacitors at the time. Embodiments of the present invention thus relate to methods as defined in the appended claims.

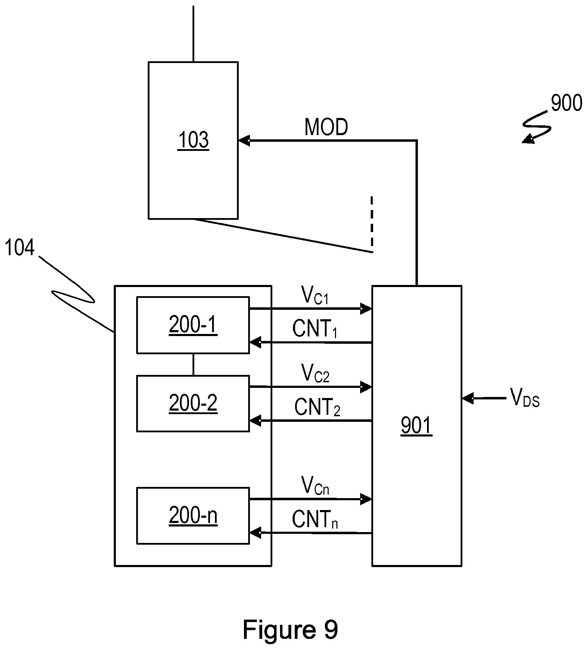

Embodiments also relate to control apparatus for director switch and/or a converter arm of a VSC, as defined in the appended claims. Figure 9 illustrates one example of a control apparatus. Figure 9 illustrates a converter arm with a chain-link 103 in series with a director switch 104. The director switch comprises a plurality of director switch units 200-1 to 200-n, each of which may have the form generally indicated in figure 2, e.g. with a clamp capacitor connected across the switching element of the director switch unit and a floating power supply that draws power from the clamp capacitor.

A director switch controller 901 is configured to receive an indication of the voltage level of the clamp capacitor V_{C1} to V_{Cn} for each of the director switch units and determine appropriate control signals CNT₁ to CNTₙ for switching of the switch elements of the director switch units at appropriate timings. The director switch controller 901 may also receive an indication V_{DS} of the voltage across the director switch 104 so as to determine that an appropriate number of switching elements are off to support the voltage.

Each director switch unit may comprise a local control unit, such as control electronics 204illustrated in figure 2, that serves several purposes such as converting the power to the gate driver electronics of the IGBTs, measuring key physical variables, such as the clamp capacitor voltage, and communicating to the director switch controller 901. As noted the director switch controller 901 receives an indication of the voltages of the clamp capacitors of the director switch units and determines appropriate control signals for control of the switching elements of the director switch units. There are various ways in which the director switch controller 901 may be arranged to communicate with the local control electronics 204 of the director switch units.

In some embodiments local measurement of the clamp capacitor voltage may be made in each director switching unit and communicated to the director switch controller 901. In some embodiments the local control electronics 204 may provide such measurements throughout the period during which the voltage balancing strategy may be applied. For instance measurements of clamp capacitor voltage may be sampled and communicated to the director switch controller 901 at a sufficient sampling rate to allow the director switch controller 901 to determine the extent of any voltage imbalance and determine the timing of appropriate control signals.

The local control unit 204 may thus be configured to send an instantaneous voltage reading of the clamp capacitor voltage to the director switch controller at periodic sampling intervals. For typical VSCs the voltage waveform imposed across the director switch does not typically change any faster than around 100 µs or so and the sampling time for communicating the clamp capacitor voltage can therefore be relatively low and readily achievable. This does however require the transfer of a relatively significant amount of data.

The communication signals and amount of data exchanged may be reduced by adopting a more distributed control hierarchy, for instance by taking advantage of the distributed configuration of the hardware in some VSC arrangements. In some VSCs the director switch units are grouped in stacks having around ten or so IGBTs. In such a configuration, the stack or stacks may be selected by a top level the control system based on their urgency to be switched, and a lower level control determining which of its IGBTs of the relevant stack should be operated. The lower level control may be at least partly implemented by a local control within the stack.

In some embodiments, to reduce the communication requirements, a measure of the clamp capacitor voltages from the director switch units could be provided to the director switch the director switch controller 901 just before a relevant switch transition of the director switch. The director switch controller 901 may then determine the degree of any voltage imbalance and need for any voltage balancing. In some embodiments the director switch controller 901 may then determine an appropriate voltage level at which the relevant switching element should be turned on or off during the subsequent transition of the director switch. This may be based on the voltage level across the director switch, in which case the director switch controller 901 may generate a switch control signal at the appropriate time, or in some embodiments the voltage level may be a voltage level of the clamp capacitor of the switching unit, in which case the director switch controller 901 may provide a control signal to the local control unit indicating an activation level at which the relevant director switching unit should operate.

Thus in some embodiments the clamp capacitor voltages from all director switch units could be read and sorted by the director switch controller 901 in advance of the director switch turn-off or turn-on process. That is, just before the waveform applied across the director switch begins to rise or fall. Each of the local control units of the director switch may then pre-programmed by the control signals CNT₁ to CNTₙ to act upon a certain clamp capacitor voltage, so that they can locally decide when to turn-off or turn-on its associated IGBT.

In embodiments where relatively continuous measurements indicating the evolution of the clamp capacitor voltages during the transition of the director switch are not provided to the director switch controller 901, the control signals for controlling the switching elements may be based on a predicted evolution of the voltages. Thus, as mentioned, the clamp capacitor voltages from all director switch units could be read and by the director switch controller 901 in advance of the director switch turn-off or turn-on process. Such measured values could be used to predict the evolution of the voltages across the director switch units, for instance by using a suitable model. Based on this prediction appropriate control signals may be generated, either by the director switch controller 901 generating the signals at an appropriate time or voltage level across the whole director switch or by the director switch controller 901 pre-programming the local control unit of the director switch units with a suitable activation level. In some embodiments at least some measurements of the actual clamp capacitor voltages may be taken during the transition of the director switch and communicated to the director switch controller 901 to update the prediction during the transition period. Only a few actual measurements may be needed to be communicated during the transition period of the director switch, which may therefore not represent an undue communication burden, and such an updated prediction may give a reasonably accurate indication of the evolution of the clamp voltages of the director switch units.

As noted previously the voltage produced by chain-link 103 may be modulated during the off period of the director switch 104 based on the switching the requirements. Thus the director switch controller 901 may also provide a modulation control signal MOD for controlling modulation of the chain-link.

The methods and apparatus described above thus achieves the balancing of the clamp capacitors, even under extreme operating conditions, such as a high constant power load being drawn in the presence of significant circuit mismatch. The techniques described herein also allow recovery of the balancing of the clamp capacitors after they have been upset by an external disturbance. Any corrective action is only taken however when the clamp capacitors are imbalanced, returning to an ideal switching pattern afterwards. This provides a very stable operation in normal conditions. The voltage across the various semiconductor switching elements is thus balanced as a consequence of balancing the clamp capacitors.

The various embodiments have been described in respect of an AAC type converter but it will be appreciated that the techniques are applicable to any type of VSC comprising a director switch formed from director switch units having a switching element and a clamp capacitor connected across the switching element. In particular the techniques are suitable where such director switch units also have a floating power supply that draws power from the clamp capacitor.

It should be noted that the above-mentioned embodiments illustrate rather than limit the invention, and that those skilled in the art will be able to design many alternative embodiments without departing from the scope of the appended claims. The word "comprising" does not exclude the presence of elements or steps other than those listed in a claim, "a" or "an" does not exclude a plurality, and a single feature or other unit may fulfil the functions of several units recited in the claims. Any reference signs in the claims shall not be construed so as to limit their scope.

## Claims

1. A method of controlling a director switch (104) of a voltage source converter wherein the director switch (104) comprises a plurality of series connected director switch units (200) each comprising a semiconductor switching element (110) and an associated clamp capacitor (202) connected across the semiconductor switching element (110), the method comprising:
switching the semiconductor switching elements (110) of the director switch units (200) to transition the director switch (104) between conducting and non-conducting states;
wherein the timing of switching of a semiconductor switching element (110) is based on the voltage level of the associated clamp capacitor (202) and the degree of any voltage imbalance between the clamp capacitors (202) of the director switch units (200);
wherein the method further comprises turning-off the semiconductor switching elements (110) of the director switch units (200) to transition the director switch (104) from a fully conducting state to a fully non-conducting state;
**characterized in that** the director switch (104) is connected in series in a converter arm with a chain-link circuit (103) for voltage wave-shaping and the method comprises modulating a voltage generated by the chain-link circuit (103) during the transition of the director switch (104) from the fully conducting state to the fully non-conducting state; and
**in that** the chain-link voltage is modulated to increase the rate of voltage increase across the director switch (104) after a given semiconductor switching element (110) has been turned off.

2. The method of claim 1, further comprising, at a first turn-off time, turning off a first set of semiconductor switching elements (110), wherein
the first set of semiconductor switching elements (110) comprises the semiconductor switching element (110) having the associated clamp capacitor (202) having the lowest voltage level and any semiconductor switching element (110) having an associated clamp capacitor (202) with a voltage level within a predetermined range of the lowest voltage level; and
in the event that not all semiconductor switching elements (110) are turned off as part of the first set at the first turn-off time, the method comprises progressively turning off the switching element (110) having the associated clamp capacitor (202) having the lowest voltage level of all switching elements that are still on at the earliest of (i) a voltage across that semiconductor switching element (110) reaching a level which is within a predetermined range of the voltage level of the clamp capacitor (202) associated with that semiconductor switching element (110) or (ii) the voltage across the director switch (104) reaching a limit based on the number of semiconductor switching elements (110) that are presently turned off.

3. The method of claim 1 or claim 2, further comprising modulating a voltage generated by the chain-link circuit (103) during a period in which the director switch (104) is off such that a voltage across the director switch (104) increase during a first period to a peak value and then is maintained at substantially said peak value during a second period.

4. A method of controlling a director switch (104) of a voltage source converter wherein the director switch (104) comprises a plurality of series connected director switch units (200) each comprising a semiconductor switching element (110) and an associated clamp capacitor (202) connected across the semiconductor switching element (110), the method comprising:
switching the semiconductor switching elements (110) of the director switch units (200) to transition the director switch (104) between conducting and non-conducting states;
wherein the timing of switching of a semiconductor switching element (110) is based on the voltage level of the associated clamp capacitor (202) and the degree of any voltage imbalance between the clamp capacitors (202) of the director switch units (200);
wherein the method further comprises turning-on the semiconductor switching elements (110) of the director switch units (200) to transition the director switch (104) from a fully non-conducting state to a fully conducting state;
**characterized in that** the director switch (104) is connected in series in a converter arm with a chain-link circuit (103) for voltage wave-shaping and the method comprises modulating a voltage generated by the chain-link circuit (103) during the transition of the director switch (104) from the fully non-conducting state to the fully conducting state; and
**in that** the chain-link voltage is modulated to decrease the rate of voltage decrease across the director switch (104) after a given semiconductor switching element (110) has been turned on.

5. The method of claim 4, further comprising,
from a first transition start time to an on-time, monitoring the voltage levels of the clamp capacitors (202) to determine whether a measure of voltage imbalance exceeds a predetermine threshold and, in the event that (i) said difference does exceed said threshold and (ii) a voltage across the director switch (104) is low enough to allow turn on of a semiconductor switching element (110), the method comprises turning on the semiconductor switching element (110) associated with the clamp capacitor (202) having the highest voltage level; and
at the on-time, turning on all semiconductor switching elements (110) that are presently turned off.

6. The method of claim 4 or claim 5, wherein,
in the event that a semiconductor switching element (110) is turned on before the on-time the method comprises determining whether a voltage level of a clamp capacitor (202) associated with a semiconductor switching element (110) that is still turned off exceeds a voltage value for the clamp capacitors (202) associated with the semiconductor switching elements (110) that have been turned on and, if so, then provided that a voltage across the director switch (104) is low enough to allow turn on of a semiconductor switching element (110) the method comprises turning said semiconductor switching element (110) on; and
the voltage value for the clamp capacitors (202) associated with the semiconductor switching elements (110) that have been turned on comprises one of: a highest voltage level and an average voltage level.

7. The method of any preceding claim, wherein each director switch unit (200) further comprises a floating power supply configured to draw power, in use, from the clamp capacitor.

8. A control apparatus configured to control a director switch (104) of a voltage source converter having a plurality of series connected director switch units (200) each comprising a semiconductor switching element (110) and an associated clamp capacitor (202) connected across the semiconductor switching element (110), wherein the control apparatus is configured to:
receive an indication of the voltage level of the associated clamp capacitors (202) of the director switch units (200); and
generate switching control signals for controlling switching the semiconductor switching elements (110) of the director switch units (200) to transition the director switch (104) between conducting and non-conducting states;
wherein the timing of switching of a semiconductor switching element (110) is based on the voltage level of the associated clamp capacitor (202) and the degree of any voltage imbalance between the clamp capacitors (202) of the director switch units (200);
wherein the control apparatus is further configured to generate:
switching control signals for turning-off the semiconductor switching elements (110) of the director switch units (200) to transition the director switch (104) from a conducting state to a non-conducting state so as to turn the director switch (104) off;
**characterized in that** the control apparatus is further configured to generate a modulation control signal for controlling modulation of modulating a voltage generated by a chain-link circuit (103) for voltage wave-shaping connected in series with the director switch (104) during a period that the director switch (104) is transitioning from a fully conducting state to a fully non-conducting state;
wherein the modulation control signal is generated so as to modulate the chain-link voltage to increase the rate of voltage increase across the director switch (104) after a given semiconductor switching element (110) has been turned off.

9. A control apparatus configured to control a director switch (104) of a voltage source converter having a plurality of series connected director switch units (200) each comprising a semiconductor switching element (110) and an associated clamp capacitor (202) connected across the semiconductor switching element (110), wherein the control apparatus is configured to:
receive an indication of the voltage level of the associated clamp capacitors (202) of the director switch units (200); and
generate switching control signals for controlling switching the semiconductor switching elements (110) of the director switch units (200) to transition the director switch (104) between conducting and non-conducting states;
wherein the timing of switching of a semiconductor switching element (110) is based on the voltage level of the associated clamp capacitor (202) and the degree of any voltage imbalance between the clamp capacitors (202) of the director switch units (200);
wherein the control apparatus is further configured to generate:
switching control signals for turning-on the semiconductor switching elements (110) of the director switch units (200) to transition the director switch (104) from a non-conducting state to a conducting state so as to turn the director switch (104) on;
**characterized in that** the control apparatus is further configured to generate a modulation control signal for controlling modulation of modulating a voltage generated by a chain-link circuit (103) for voltage wave-shaping connected in series with the director switch (104) during a period that the director switch (104) is transitioning from a fully non-conducting state to a fully conducting state;
wherein the modulation control signal is generated so as to modulate the chain-link voltage to decrease the rate of voltage decrease across the director switch after a given semiconductor switching element (110) has been turned on.

10. The control apparatus of claim 8 or claim 9, wherein the control apparatus is configured to receive, from each director switch unit (200), repeated measurements of the voltage level of the associated clamp capacitor (202) throughout a period of a director switch transition as said indication of the voltage level of the associated clamp capacitors (202) of the director switch units (200).

11. The control apparatus of any of claims 8 to 10, wherein the control apparatus is configured to receive, from each director switch unit (200), a measurement of the voltage level of the associated clamp capacitor (202) prior to a director switch transition as said indication of the voltage level of the associated clamp capacitors (202) of the director switch units (200).

12. The control apparatus of claim 11, wherein said switching control signals comprise a control signal for a director switch unit (200) to turn on or off at a particular clamp voltage level.

13. The control apparatus of claims 11 or claim 12, wherein the control apparatus is configured to predict a voltage evolution for the voltages of the director switching units (200) based on said received measurement of the voltage level of the associated clamp capacitors (202) of the director switching units (200) and to generate the switching control signals based on the predicted voltage evolution, wherein the control apparatus is configured to update said predicted voltage evolution based on one or more measurements of the voltage level of the clamp capacitors (202) of the director switching units (110) received during the period of a director switch transition.

14. A converter arm apparatus for a voltage source converter comprising:
a director switch (104) comprising a plurality of series connected director switch units (200) each comprising a semiconductor switching element (110) and an associated clamp capacitor (202) connected across the semiconductor switching element (110); and
a control apparatus (204) as claimed in any of claims 8 to 13.

15. A voltage source converter comprising at least one phase limb having two converter arms, each converter arm comprising a converter arm apparatus as claimed in claim 14.

## Patentansprüche

1. Verfahren zum Steuern eines Steuerschalters (104) eines spannungsgeführten Wandlers, wobei der Steuerschalter (104) eine Vielzahl von in Reihe geschalteten Steuerschaltereinheiten (200) umfasst, die jeweils ein Halbleiterschaltelement (110) und einen zugehörigen Klemmenkondensator (202) umfassen, der parallel zu dem Halbleiterschaltelement (110) geschaltet ist, wobei das Verfahren umfasst:
derartiges Schalten der Halbleiterschaltelemente (110) der Steuerschaltereinheiten (200), dass der Steuerschalter (104) zwischen einem leitenden und nichtleitenden Zustand wechselt;
wobei der Zeitpunkt für das Schalten eines Halbleiterschaltelements (110) auf dem Spannungspegel des zugehörigen Klemmenkondensators (202) und dem Grad einer Spannungsunsymmetrie zwischen den Klemmenkondensatoren (202) der Steuerschaltereinheiten (200) basiert;
wobei das Verfahren weiter ein derartiges Ausschalten der Halbleiterschaltelemente (110) der Steuerschaltereinheiten (200) umfasst, dass der Steuerschalter (104) aus einem vollständig leitenden Zustand in einen vollständig nichtleitenden Zustand wechselt;
**dadurch gekennzeichnet, dass** der Steuerschalter (104) zwecks Beeinflussung von Spannungskurven in einem Wandlerarm in Reihe mit einer Verkettungsschaltung (103) geschaltet ist und das Verfahren ein Modulieren einer Spannung umfasst, die von der Verkettungsschaltung (103) während des Übergangs des Steuerschalters (104) aus dem vollständig leitenden Zustand in den vollständig nichtleitenden Zustand erzeugt wird; und
dadurch, dass die Verkettungsspannung so moduliert wird, dass sich die Rate des Spannungsanstiegs am Steuerschalter (104) erhöht, nachdem ein bestimmtes Halbleiterschaltelement (110) ausgeschaltet wurde.

2. Verfahren nach Anspruch 1, das weiter zu einem ersten Ausschaltzeitpunkt ein Ausschalten einer ersten Gruppe von Halbleiterschaltelementen (110) umfasst, wobei
die erste Gruppe von Halbleiterschaltelementen (110) das Halbleiterschaltelement (110), das den zugehörigen Klemmenkondensator (202) mit dem geringsten Spannungspegel aufweist, und jedes beliebige Halbleiterschaltelement (110) umfasst, das einen zugehörigen Klemmenkondensator (202) mit einem Spannungspegel innerhalb eines vorgegebenen Bereichs des geringsten Spannungspegels aufweist; und
falls nicht sämtliche Halbleiterschaltelemente (110) als Bestandteil der ersten Gruppe zum ersten Ausschaltzeitpunkt ausgeschaltet werden, das Verfahren ein allmählich erfolgendes Ausschalten des Schaltelements (110) umfasst, das den zugehörigen Klemmenkondensator (202) mit dem geringsten Spannungspegel sämtlicher Schaltelemente aufweist, die zum frühesten Zeitpunkt von folgenden Zeitpunkten weiterhin eingeschaltet sind: (i) wenn eine Spannung an diesem Halbleiterschaltelement (110) einen Pegel innerhalb eines vorgegebenen Bereichs des Spannungspegels des Klemmenkondensators (202) erreicht, der diesem Halbleiterschaltelement (110) zugehörig ist, oder (ii) wenn die Spannung am Steuerschalter (104) einen Grenzwert auf Grundlage der Anzahl von aktuell ausgeschalteten Halbleiterschaltelemente (110) erreicht.

3. Verfahren nach Anspruch 1 oder Anspruch 2, weiter umfassend ein Modulieren einer Spannung, die von der Verkettungsschaltung (103) während eines Zeitraums erzeugt wird, in der der Steuerschalter (104) ausgeschaltet ist, sodass eine Spannung am Steuerschalter (104) während eines ersten Zeitraums auf einen Höchstwert ansteigt und dann während eines zweiten Zeitraums auf im Wesentlichen dem Höchstwert gehalten wird.

4. Verfahren zum Steuern eines Steuerschalters (104) eines spannungsgeführten Wandlers, wobei der Steuerschalter (104) eine Vielzahl von in Reihe geschalteten Steuerschaltereinheiten (200) umfasst, die jeweils ein Halbleiterschaltelement (110) und einen zugehörigen Klemmenkondensator (202) umfassen, der parallel zu dem Halbleiterschaltelement (110) geschaltet ist, wobei das Verfahren umfasst:
derartiges Schalten der Halbleiterschaltelemente (110) der Steuerschaltereinheiten (200), dass der Steuerschalter (104) zwischen einem leitenden und nichtleitenden Zustand wechselt;
wobei der Zeitpunkt für das Schalten eines Halbleiterschaltelements (110) auf dem Spannungspegel des zugehörigen Klemmenkondensators (202) und dem Grad einer Spannungsunsymmetrie zwischen den Klemmenkondensatoren (202) der Steuerschaltereinheiten (200) basiert;
wobei das Verfahren weiter ein derartiges Einschalten der Halbleiterschaltelemente (110) der Steuerschaltereinheiten (200) umfasst, dass der Steuerschalter (104) aus einem vollständig nichtleitenden Zustand in einen vollständig leitenden Zustand wechselt;
**dadurch gekennzeichnet, dass** der Steuerschalter (104) zwecks Beeinflussung von Spannungskurven in einem Wandlerarm in Reihe mit einer Verkettungsschaltung (103) geschaltet ist und das Verfahren ein Modulieren einer Spannung umfasst, die von der Verkettungsschaltung (103) während des Übergangs des Steuerschalters (104) aus dem vollständig nichtleitenden Zustand in den vollständig leitenden Zustand erzeugt wird; und
dadurch, dass die Verkettungsspannung so moduliert wird, dass die Rate des Spannungsabfalls am Steuerschalter (104) abnimmt, nachdem ein bestimmtes Halbleiterschaltelement (110) eingeschaltet wurde.

5. Verfahren nach Anspruch 4, weiter umfassend:
Überwachen, von einem ersten Wechselstartzeitpunkt bis zu einem Einschaltzeitpunkt, der Spannungspegel der Klemmenkondensatoren (202), um festzustellen, ob ein Maß für eine Spannungsunsymmetrie einen vorgegebenen Schwellenwert übersteigt, und falls (i) die Differenz den Schwellenwert übersteigt und (ii) eine Spannung am Steuerschalter (104) gering genug ist, dass sie ein Einschalten eines Halbleiterschaltelements (110) zulässt, umfasst das Verfahren ein Einschalten des Halbleiterschaltelements (110), das dem Klemmenkondensator (202) mit dem höchsten Spannungspegel zugehörig ist; und
zum Einschaltzeitpunkt Einschalten sämtlicher Halbleiterschaltelemente (110), die aktuell ausgeschaltet sind.

6. Verfahren nach Anspruch 4 oder Anspruch 5, wobei,
falls ein Halbleiterschaltelement (110) vor dem Einschaltzeitpunkt eingeschaltet wird, das Verfahren ein Feststellen umfasst, ob ein Spannungspegel eines Klemmenkondensators (202), der einem Halbleiterschaltelement (110) zugehörig ist, das noch ausgeschaltet ist, einen Spannungswert für die Klemmenkondensatoren (202) übersteigt, der den Halbleiterschaltelementen (110) zugehörig ist, die eingeschaltet wurden, und wenn dies zutrifft, sofern eine Spannung am Steuerschalter (104) gering genug ist, dass ein Einschalten eines Halbleiterschaltelements (110) ermöglicht wird, das Verfahren ein Einschalten des Halbleiterschaltelements (110) umfasst; und
der Spannungswert für die Klemmenkondensatoren (202), die den Halbleiterschaltelementen (110) zugehörig sind, die eingeschaltet wurden, eines umfasst von: einem höchsten Spannungspegel und einem durchschnittlichen Spannungspegel.

7. Verfahren nach einem vorstehenden Anspruch, wobei jede Steuerschalteinheit (200) weiter eine potentialfreie Stromversorgung umfasst, die so eingerichtet ist, dass sie im Einsatz Strom aus dem Klemmenkondensator bezieht.

8. Steuereinrichtung, die so eingerichtet ist, dass sie einen Steuerschalter (104) eines spannungsgeführten Wandlers steuert, der eine Vielzahl von in Reihe geschalteten Steuerschaltereinheiten (200) aufweist, die jeweils ein Halbleiterschaltelement (110) und einen zugehörigen Klemmenkondensator (202) umfassen, der parallel zu dem Halbleiterschaltelement (110) geschaltet ist, wobei die Steuereinrichtung so eingerichtet ist, dass sie:
eine Angabe für den Spannungspegel der zugehörigen Klemmenkondensatoren (202) der Steuerschalteinheiten (200) empfängt; und
Schaltsteuersignale zum derartigen Schalten der Halbleiterschaltelemente (110) der Steuerschaltereinheiten (200) erzeugt, dass der Steuerschalter (104) zwischen einem leitenden und nichtleitenden Zustand wechselt;
wobei der Zeitpunkt für das Schalten eines Halbleiterschaltelements (110) auf dem Spannungspegel des zugehörigen Klemmenkondensators (202) und dem Grad einer Spannungsunsymmetrie zwischen den Klemmenkondensatoren (202) der Steuerschaltereinheiten (200) basiert;
wobei die Steuereinrichtung weiter so eingerichtet ist, dass sie:
Schaltsteuersignale zum derartigen Ausschalten der Halbleiterschaltelemente (110) der Steuerschaltereinheiten (200) erzeugt, dass der Steuerschalter (104) aus einem leitenden Zustand in einen nichtleitenden Zustand wechselt und so den Steuerschalter (104) ausschaltet;
**dadurch gekennzeichnet, dass** die Steuereinrichtung weiter so eingerichtet ist, dass sie ein Modulationssteuersignal zur Modulationssteuerung zum Modulieren einer Spannung erzeugt, die von einer Verkettungsschaltung (103), die in Reihe mit dem Steuerschalter (104) geschaltet ist, zwecks Gestaltung von Spannungskurven während eines Zeitraums erzeugt wird, in dem der Steuerschalter (104) aus einem vollständig leitenden Zustand in einen vollständig nichtleitenden Zustand wechselt;
wobei das Modulationssteuersignal so erzeugt wird, dass es die Verkettungsspannung so moduliert, dass sich die Rate des Spannungsanstiegs am Steuerschalter (104) erhöht, nachdem ein bestimmtes Halbleiterschaltelement (110) ausgeschaltet wurde.

9. Steuereinrichtung, die so eingerichtet ist, dass sie einen Steuerschalter (104) eines spannungsgeführten Wandlers steuert, der eine Vielzahl von in Reihe geschalteten Steuerschaltereinheiten (200) aufweist, die jeweils ein Halbleiterschaltelement (110) und einen zugehörigen Klemmenkondensator (202) umfassen, der parallel zu dem Halbleiterschaltelement (110) geschaltet ist, wobei die Steuereinrichtung so eingerichtet ist, dass sie:
eine Angabe für den Spannungspegel der zugehörigen Klemmenkondensatoren (202) der Steuerschalteinheiten (200) empfängt; und
Schaltsteuersignale zum derartigen Schalten der Halbleiterschaltelemente (110) der Steuerschaltereinheiten (200) erzeugt, dass der Steuerschalter (104) zwischen einem leitenden und nichtleitenden Zustand wechselt;
wobei der Zeitpunkt für das Schalten eines Halbleiterschaltelements (110) auf dem Spannungspegel des zugehörigen Klemmenkondensators (202) und dem Grad einer Spannungsunsymmetrie zwischen den Klemmenkondensatoren (202) der Steuerschaltereinheiten (200) basiert;
wobei die Steuereinrichtung weiter so eingerichtet ist, dass sie:
Schaltsteuersignale zum derartigen Einschalten der Halbleiterschaltelemente (110) der Steuerschaltereinheiten (200) erzeugt, dass der Steuerschalter (104) aus einem nichtleitenden Zustand in einen leitenden Zustand wechselt und so den Steuerschalter (104) einschaltet;
**dadurch gekennzeichnet, dass** die Steuereinrichtung weiter so eingerichtet ist, dass sie ein Modulationssteuersignal zur Modulationssteuerung zum Modulieren einer Spannung erzeugt, die von einer Verkettungsschaltung (103), die in Reihe mit dem Steuerschalter (104) geschaltet ist, zwecks Gestaltung von Spannungskurven während eines Zeitraums erzeugt wird, in dem der Steuerschalter (104) aus einem vollständig nichtleitenden Zustand in einen vollständig leitenden Zustand wechselt;
wobei das Modulationssteuersignal so erzeugt wird, dass es die Verkettungsspannung so moduliert, dass die Rate des Spannungsabfalls am Steuerschalter abnimmt, nachdem ein bestimmtes Halbleiterschaltelement (110) eingeschaltet wurde.

10. Steuereinrichtung nach Anspruch 8 oder Anspruch 9, wobei die Steuereinrichtung so eingerichtet ist, dass sie von jeder Steuerschalteinheit (200) wiederholte Messwerte für den Spannungspegel des zugehörigen Klemmenkondensators (202) über einen Zeitraum eines Steuerschalterwechsels als die Angabe zum Spannungspegel der zugehörigen Klemmenkondensatoren (202) der Steuerschalteinheiten (200) empfängt.

11. Steuereinrichtung nach Anspruch 8 bis 10, wobei die Steuereinrichtung so eingerichtet ist, dass sie von jeder Steuerschalteinheit (200) einen Messwert für den Spannungspegel des zugehörigen Klemmenkondensators (202) vor einem Steuerschalterwechsels als die Angabe zum Spannungspegel der zugehörigen Klemmenkondensatoren (202) der Steuerschalteinheiten (200) empfängt.

12. Steuereinrichtung nach Anspruch 11, wobei die Schaltsteuersignale ein Steuersignal für eine Steuerschalteinheit (200) zum Ein- oder Ausschalten bei einem bestimmten Klemmenspannungspegel umfassen.

13. Steuereinrichtung nach Anspruch 11 oder Anspruch 12, wobei die Steuereinrichtung so eingerichtet ist, dass sie eine Spannungsentwicklung für die Spannungen der Steuerschalteinheiten (200) auf Grundlage des empfangenen Messwerts für den Spannungspegel der zugehörigen Klemmenkondensatoren (202) der Steuerschalteinheiten (200) voraussagt und auf Grundlage der vorausgesagten Spannungsentwicklung die Schaltsteuersignale erzeugt, wobei die Steuereinrichtung so eingerichtet ist, dass sie die vorhergesagte Spannungsentwicklung auf Grundlage von einem oder mehreren Messwerten für den Spannungspegel der Klemmenkondensatoren (202) der Steuerschalteinheiten (110) aktualisiert, die während des Zeitraums eines Steuerschalterwechsels empfangen werden.

14. Wandlerarmeinrichtung für einen spannungsgeführten Wandler, umfassend:
einen Steuerschalter (104), der eine Vielzahl von in Reihe geschalteten Steuerschaltereinheiten (200) umfasst, die jeweils ein Halbleiterschaltelement (110) und einen zugehörigen Klemmenkondensator (202) umfassen, der parallel zu dem Halbleiterschaltelement (110) geschaltet ist, und
eine Steuereinrichtung (204) nach einem der Ansprüche 8 bis 13.

15. Spannungsgeführter Wandler, der mindestens einen Phasenschenkel mit zwei Wandlerarmen umfasst, wobei jeder Wandlerarm eine Wandlerarmeinrichtung nach Anspruch 14 umfasst.

## Revendications

1. Procédé de commande d'un commutateur directeur (104) d'un convertisseur de source de tension dans lequel le commutateur directeur (104) comprend une pluralité d'unités de commutateur directeur (200) connectées en série comprenant chacune un élément de commutation à semi-conducteur (110) et un condensateur d'arrêt associé (202) connecté à travers l'élément de commutation à semi-conducteur (110), le procédé comprenant :
la commutation des éléments de commutation à semi-conducteur (110) des unités de commutateur directeur (200) pour faire passer le commutateur directeur (104) entre des états conducteur et non conducteur ;
dans lequel la temporisation de commutation d'un élément de commutation à semi-conducteur (110) est basée sur le niveau de tension du condensateur d'arrêt associé (202) et le degré d'un quelconque déséquilibre de tension entre les condensateurs d'arrêt (202) des unités de commutateur directeur (200) ;
dans lequel le procédé comprend en outre la mise à l'arrêt des éléments de commutation à semi-conducteur (110) des unités de commutateur directeur (200) pour faire passer le commutateur directeur (104) d'un état complètement conducteur à un état complètement non conducteur ;
**caractérisé en ce que** le commutateur directeur (104) est connecté en série dans un bras de convertisseur à un circuit de liaison en chaîne (103) pour mise en forme d'onde de tension et le procédé comprend la modulation d'une tension générée par le circuit de liaison en chaîne (103) pendant la transition du commutateur directeur (104) de l'état complètement conducteur à l'état complètement non conducteur ; et
**en ce que** la tension de liaison en chaîne est modulée pour augmenter le taux d'augmentation de tension à travers le commutateur directeur (104) après qu'un élément de commutation à semi-conducteur (110) donné a été mis à l'arrêt.

2. Procédé selon la revendication 1, comprenant en outre, au niveau d'un premier temps de mise à l'arrêt, la mise à l'arrêt d'un premier ensemble d'éléments de commutation à semi-conducteur (110), dans lequel
le premier ensemble d'éléments de commutation à semi-conducteur (110) comprend l'élément de commutation à semi-conducteur (110) ayant le condensateur d'arrêt associé (202) ayant le plus faible niveau de tension et n'importe quel élément de commutation à semi-conducteur (110) ayant un condensateur d'arrêt associé (202) avec un niveau de tension à l'intérieur d'une plage prédéterminée du plus faible niveau de tension ; et
dans l'éventualité où tous les éléments de commutation à semi-conducteur (110) ne seraient pas mis à l'arrêt dans le cadre du premier ensemble au niveau du premier temps de mise à l'arrêt, le procédé comprend la mise à l'arrêt progressive de l'élément de commutation (110) ayant le condensateur d'arrêt associé (202) ayant le plus faible niveau de tension de tous les éléments de commutation qui sont toujours actifs au niveau du premier en temps parmi (i) une tension à travers cet élément de commutation à semi-conducteur (110) atteignant un niveau qui est à l'intérieur d'une plage prédéterminée du niveau de tension du condensateur d'arrêt (202) associé à cet élément de commutation à semi-conducteur (110) ou (ii) la tension à travers le commutateur directeur (104) atteignant une limite sur la base du nombre d'éléments de commutation à semi-conducteur (110) qui sont actuellement mis à l'arrêt.

3. Procédé selon la revendication 1 ou la revendication 2, comprenant en outre la modulation d'une tension générée par le circuit de liaison en chaîne (103) pendant une période pendant laquelle le commutateur directeur (104) est à l'arrêt de sorte qu'une tension à travers le commutateur directeur (104) augmente pendant une première période jusqu'à une valeur de crête puis est maintenue sensiblement au niveau de ladite valeur de crête pendant une deuxième période.

4. Procédé de commande d'un commutateur directeur (104) d'un convertisseur de source de tension dans lequel le commutateur directeur (104) comprend une pluralité d'unités de commutateur directeur (200) connectées en série comprenant chacune un élément de commutation à semi-conducteur (110) et un condensateur d'arrêt associé (202) connecté à travers l'élément de commutation à semi-conducteur (110), le procédé comprenant :
la commutation des éléments de commutation à semi-conducteur (110) des unités de commutateur directeur (200) pour faire passer le commutateur directeur (104) entre des états conducteur et non conducteur ;
dans lequel la temporisation de commutation d'un élément de commutation à semi-conducteur (110) est basée sur le niveau de tension du condensateur d'arrêt associé (202) et le degré d'un quelconque déséquilibre de tension entre les condensateurs d'arrêt (202) des unités de commutateur directeur (200) ;
dans lequel le procédé comprend en outre la mise en marche des éléments de commutation à semi-conducteur (110) des unités de commutateur directeur (200) pour faire passer le commutateur directeur (104) d'un état complètement non conducteur à un état complètement conducteur ;
**caractérisé en ce que** le commutateur directeur (104) est connecté en série dans un bras de convertisseur à un circuit de liaison en chaîne (103) pour une mise en forme d'onde de tension et le procédé comprend la modulation d'une tension générée par le circuit de liaison en chaîne (103) pendant la transition du commutateur directeur (104) de l'état complètement non conducteur à l'état complètement conducteur ; et
**en ce que** la tension de liaison en chaîne est modulée pour diminuer le taux de diminution de tension à travers le commutateur directeur (104) après qu'un élément de commutation à semi-conducteur (110) donné a été mis en marche.

5. Procédé selon la revendication 4, comprenant en outre
à partir d'un moment de début de première transition jusqu'à un temps de marche, la surveillance des niveaux de tension des condensateurs d'arrêt (202) pour déterminer si une mesure de déséquilibre de tension dépasse un seuil prédéterminé et, dans l'éventualité où (i) ladite différence dépasserait ledit seuil et (ii) qu'une tension à travers le commutateur directeur (104) serait suffisamment basse pour permettre la mise en marche d'un élément de commutation à semi-conducteur (110), le procédé comprend la mise en marche de l'élément de commutation à semi-conducteur (110) associé au condensateur d'arrêt (202) ayant le niveau de tension le plus élevé ; et
au niveau du temps de marche, la mise en marche de tous les éléments de commutation à semi-conducteur (110) qui sont actuellement mis à l'arrêt.

6. Procédé selon la revendication 4 ou la revendication 5, dans lequel
dans l'éventualité où un élément de commutation à semi-conducteur (110) serait mis en marche avant le temps de marche le procédé comprend le fait de déterminer si un niveau de tension d'un condensateur d'arrêt (202) associé à un élément de commutation à semi-conducteur (110) qui est toujours mis à l'arrêt dépasse une valeur de tension pour les condensateurs d'arrêt (202) associés aux éléments de commutation à semi-conducteur (110) qui ont été mis en marche et, dans l'affirmative, à condition alors qu'une tension à travers le commutateur directeur (104) soit suffisamment basse pour permettre la mise en marche d'un élément de commutation à semi-conducteur (110) le procédé comprend la mise en marche dudit élément de commutation à semi-conducteur (110) ; et
la valeur de tension pour les condensateurs d'arrêt (202) associés aux éléments de commutation à semi-conducteur (110) qui ont été mis en marche comprend l'un parmi : un niveau de tension le plus élevé et un niveau moyen de tension.

7. Procédé selon une quelconque revendication précédente, dans lequel chaque unité de commutateur directeur (200) comprend en outre une source de puissance flottante configurée pour prélever de la puissance, en cours d'utilisation, à partir du condensateur d'arrêt.

8. Appareil de commande configuré pour commander un commutateur directeur (104) d'un convertisseur de source de tension ayant une pluralité d'unités de commutateur directeur (200) connectées en série comprenant chacune un élément de commutation à semi-conducteur (110) et un condensateur d'arrêt associé (202) connecté à travers l'élément de commutation à semi-conducteur (110), dans lequel l'appareil de commande est configuré pour :
recevoir une indication du niveau de tension des condensateurs d'arrêt associés (202) des unités de commutateur directeur (200) ; et
générer des signaux de commande de commutation pour commander la commutation des éléments de commutation à semi-conducteur (110) des unités de commutateur directeur (200) pour faire passer le commutateur directeur (104) entre les états conducteur et non conducteur ;
dans lequel la temporisation de commutation d'un élément de commutation à semi-conducteur (110) est basée sur le niveau de tension du condensateur d'arrêt associé (202) et le degré d'un quelconque déséquilibre de tension entre les condensateurs d'arrêt (202) des unités de commutateur directeur (200) ;
dans lequel l'appareil de commande est en outre configuré pour générer :
des signaux de commande de commutation pour mettre à l'arrêt les éléments de commutation à semi-conducteur (110) des unités de commutateur directeur (200) pour faire passer le commutateur directeur (104) d'un état conducteur à un état non conducteur de façon à mettre à l'arrêt le commutateur directeur (104) ;
**caractérisé en ce que** l'appareil de commande est en outre configuré pour générer un signal de commande de modulation pour commander la modulation d'une modulation d'une tension générée par un circuit de liaison en chaîne (103) pour une mise en forme d'onde de tension connecté en série au commutateur directeur (104) pendant une période pendant laquelle le commutateur directeur (104) est en train de passer d'un état complètement conducteur à un état complètement non conducteur ;
dans lequel le signal de commande de modulation est généré de façon à moduler la tension de liaison en chaîne pour augmenter le taux d'augmentation de tension à travers le commutateur directeur (104) après qu'un élément de commutation à semi-conducteur (110) donné a été mis à l'arrêt.

9. Appareil de commande configuré pour commander un commutateur directeur (104) d'un convertisseur de source de tension ayant une pluralité d'unités de commutateur directeur (200) connectées en série comprenant chacune un élément de commutation à semi-conducteur (110) et un condensateur d'arrêt associé (202) connecté à travers l'élément de commutation à semi-conducteur (110), dans lequel l'appareil de commande est configuré pour :
recevoir une indication du niveau de tension des condensateurs d'arrêt associés (202) des unités de commutateur directeur (200) ; et
générer des signaux de commande de commutation pour commander la commutation des éléments de commutation à semi-conducteur (110) des unités de commutateur directeur (200) pour faire passer le commutateur directeur (104) entre les états conducteur et non conducteur ;
dans lequel la temporisation de commutation d'un élément de commutation à semi-conducteur (110) est basée sur le niveau de tension du condensateur d'arrêt associé (202) et le degré d'un quelconque déséquilibre de tension entre les condensateurs d'arrêt (202) des unités de commutateur directeur (200) ;
dans lequel l'appareil de commande est en outre configuré pour générer :
des signaux de commande de commutation pour mettre en marche les éléments de commutation à semi-conducteur (110) des unités de commutateur directeur (200) pour faire passer le commutateur directeur (104) d'un état non conducteur à un état conducteur de façon à mettre en marche le commutateur directeur (104) ;
**caractérisé en ce que** l'appareil de commande est en outre configuré pour générer un signal de commande de modulation pour commander la modulation d'une modulation d'une tension générée par un circuit de liaison en chaîne (103) pour une mise en forme d'onde de tension connecté en série au commutateur directeur (104) pendant une période pendant laquelle le commutateur directeur (104) est en train de passer d'un état complètement non conducteur à un état complètement conducteur ;
dans lequel le signal de commande de modulation est généré de façon à moduler la tension de liaison en chaîne pour diminuer le taux de diminution de tension à travers le commutateur directeur après qu'un élément de commutation à semi-conducteur (110) donné a été mis en marche.

10. Appareil de commande selon la revendication 8 ou la revendication 9, dans lequel l'appareil de commande est configuré pour recevoir, à partir de chaque unité de commutateur directeur (200), des mesures répétées du niveau de tension du condensateur d'arrêt associé (202) sur l'ensemble d'une période d'une transition de commutateur directeur en tant qu'indication précitée du niveau de tension des condensateurs d'arrêt associés (202) des unités de commutateur directeur (200).

11. Appareil de commande selon l'une quelconque des revendications 8 à 10, dans lequel l'appareil de commande est configuré pour recevoir, à partir de chaque unité de commutateur directeur (200), une mesure du niveau de tension du condensateur d'arrêt associé (202) avant une transition de commutateur directeur en tant qu'indication précitée du niveau de tension des condensateurs d'arrêt associés (202) des unités de commutateur directeur (200).

12. Appareil de commande selon la revendication 11, dans lequel lesdits signaux de commande de commutation comprennent un signal de commande permettant à une unité de commutateur directeur (200) de se mettre en marche ou à l'arrêt à un niveau de tension d'arrêt particulier.

13. Appareil de commande selon les revendications 11 ou la revendication 12, dans lequel l'appareil de commande est configuré pour prédire une évolution de tension pour les tensions des unités de commutateur directeur (200) sur la base de ladite mesure reçue du niveau de tension des condensateurs d'arrêt associés (202) des unités de commutateur directeur (200) et pour générer les signaux de commande de commutation sur la base de l'évolution de tension prédite, dans lequel l'appareil de commande est configuré pour mettre à jour ladite évolution de tension prédite sur la base d'une ou plusieurs mesures du niveau de tension des condensateurs d'arrêt (202) des unités de commutateur directeur (110) reçues pendant la période d'une transition de commutateur directeur.

14. Appareil de bras de convertisseur pour un convertisseur de source de tension comprenant :
un commutateur directeur (104) comprenant une pluralité d'unités de commutateur directeur (200) connectées en série comprenant chacune un élément de commutation à semi-conducteur (110) et un condensateur d'arrêt associé (202) connecté à travers l'élément de commutation à semi-conducteur (110) ; et
un appareil de commande (204) tel que revendiqué dans l'une quelconque des revendications 8 à 13.

15. Convertisseur de source de tension comprenant au moins une branche de phase ayant deux bras de convertisseur, chaque bras de convertisseur comprenant un appareil de bras de convertisseur tel que revendiqué dans la revendication 14.
